# EUROPEAN PATENT SPECIFICATION

(11) **EP 1 833 058 B1**
(45) Date of publication and mention of the grant of the patent: **11.08.2010**
(21) Application number: 06425164.8
(22) Date of filing: 10.03.2006
(51) Int. Cl.: G11C 16/10

(54) **Method for programming/erasing a non volatile memory cell device, in particular for flash type memories**
Verfahren zum Programmieren und Löschen eines nichtflüchtigen Speichers, insbesonders für Flash-Typ Speicher.
Procéde de programmation et d'effacement d'une mémoire non-volatile, en particulier pour les mémoires de type FLASH.

(43) Date of publication of application: 12.09.2007
(73) Proprietor: STMicroelectronics Srl, 20041 Agrate Brianza (MB) (IT); Politecnico Di Milano, 20133 Milano (IT)
(72) Inventor: Visconti, Angelo, I-22070 Appiano Gentile (CO) (IT); Bonanomi, Mauro, I-20062 Cassano d'Adda (MI) (IT); Ielmini, Daniele, I-24124 Bergamo (IT); Spinelli, Alessandro, I-24128 Bergamo (IT)
(74) Representative: Turi, Michael

(56) References cited:
- FR-A- 2 809 858
- N. MIELKE ET AL: "Flash EEPROM Threshold Instabilities due to Charge Trapping During Program/Erase Cycling" IEEE TRANSACTIONS ON DEVICE AND MATERIALS RELIABILITY, vol. 4, no. 3, 9 July 2004 (2004-07-09), pages 335-344, XP002406672

## Description

### Field of application

The present invention relates to a method for programming/erasing a non volatile memory cell device.

The invention particularly, but not exclusively, relates to a non volatile memory device of the Flash NOR type and the following description is made with reference to this field of application in order to simplify its disclosure.

### Prior art

As it is well known, the methods for programming/erasing non volatile memory electronic devices act on the charge contained in floating gate terminals of memory cells included in these devices.

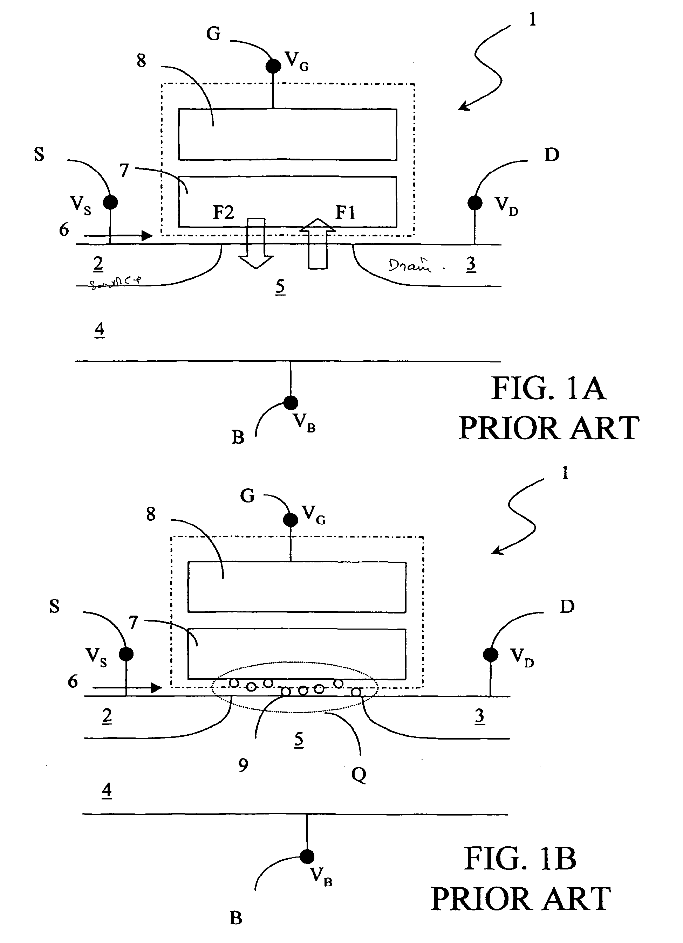

In particular, as schematically shown in Figure 1A, a non volatile memory cell 1 comprises a source region 2 and a drain region 3, realised in a semiconductor substrate 4 and provided with respective source S and drain D electrodes. Also the semiconductor substrate is provided with a substrate electrode B or bulk.

The cell 1 also comprises a floating gate 7, realised above the semiconductor substrate 4, in particular above a channel region 5, and insulated therefrom by a tunnel oxide layer 6. A control gate 8 is also placed above the floating gate 7, separated therefrom by an insulating layer, and in turn connected to a gate electrode G.

In a non volatile memory device, for example memories of the EPROM and Flash EEPROM type with NOR architecture, the non volatile memory cells 1 are organised in a matrix and associated with a control circuitry comprising a plurality of MOS transistors.

The operations of programming/erasing non volatile memory cells 1 provide the application of suitable voltage values to the cell terminals. Figure 1A indicates these voltage values applied to the gate G, source S, drain D and substrate B terminals respectively as V_{G}, Vs, V_{D} and V_{B}.

In particular, the overcoming of suitable voltage values at the terminals of the memory cell 1, usually called "programming/erasing voltages", starts the transfer of electrons and thus the passage of charge from the semiconductor substrate 4 to the floating gate 7 and vice versa, as indicated in the Figure by the arrows F1 and F2.

It is also known that the duration and reliability of non volatile memory devices thus realised is linked to the accumulation of electric charge in the tunnel oxide layer 6 of the memory cells 1, comprised therein, this accumulation being linked to the repeated programming/erasing operations. In particular, the passage of electric current in the tunnel oxide layer 6 during these operations generates electronic states wherein the charge carriers remain trapped, as schematically shown in Figure 1B where 9 indicates the carriers or accumulated charges.

This problem is deeply described in the documents published in the name of N. Mielke et al, "Flash EEPROM Threshold Instabilities due to Charge Trapping during Program/Erase Cycling", TDMR 2004 and in the name of Yamada et al, "Analysis of Detrap Current due to Oxide Traps to Improve Flash Memory Retention", IRPS 2000.

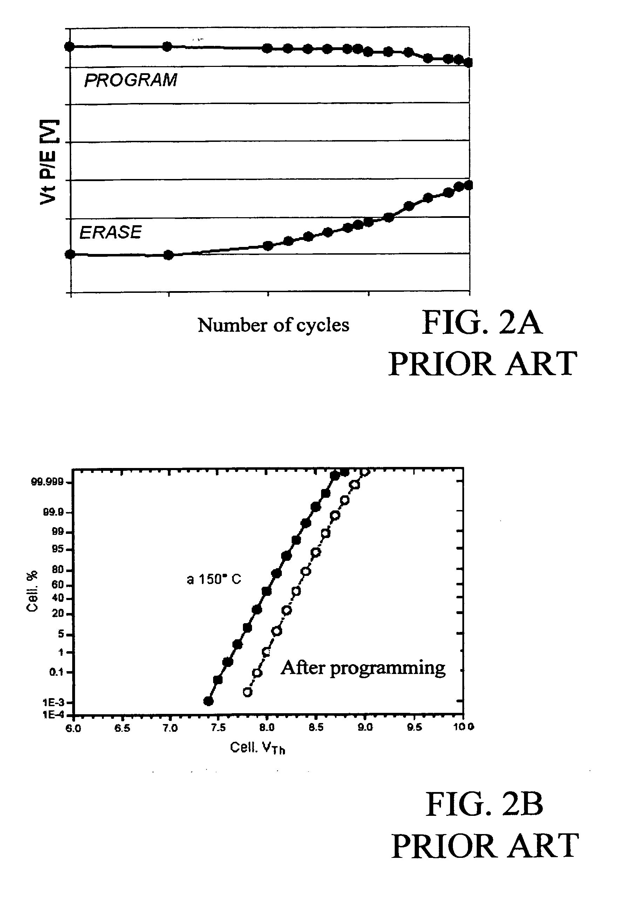

A first effect of this charge accumulation is that of making the writing operations of the memory cell 1 less efficient. In fact, it occurs that the cell programming and erasing threshold values become function of the number of programming/erasing cycles. In particular, by repeatedly programming and erasing a memory cell 1 of the Flash type, with fixed time conditions and writing pulse voltage, a trend of these programming and erasing threshold values is obtained according to the number of programming/erasing P/E cycles as the one schematically represented in Figure 2A.

Then, so as to ensure, during the entire life of the memory device, predetermined threshold voltage levels, which correspond to determined logic levels stored in the memory cells, the programming/erasing methods provide an increase of times and/or voltages of the writing pulses to compensate the loss of efficiency of the writing itself. This however induces an increase in the programming/erasing times which, in the worse cases, can lead to an "off-specification", i.e. to devices which no longer respect the design specifications and thus the limits of the applications they are intended for.

A second problem due to the accumulation of charge in the oxide is the one linked to its successive release during the operation of the memory device. In particular, when a memory cell 1 is not in the writing step, the charge accumulated during the cycling of programming/erasing operations tends to naturally relax and thus it is released by the traps towards the channel region 5 or the floating gate 7, according to the electric potentials applied to the terminals of the memory cell 1.

For example, considering a memory cell 1 in retention of a first logic value represented by a first threshold voltage Vth1 and established for the memory cell 1 after a writing step, the "natural" charge release can be high enough as to remarkably alter the electric field in the tunnel oxide layer 6, to which this charge contributes together with the charge present in the floating gate 7. In this case, at a successive reading step of the cell itself, a threshold voltage value Vth1' is measured, the voltage being different from this first threshold voltage Vth1, thus leading to a possible reading error of the logic datum stored in the memory cell 1.

Figure 2B shows the threshold voltage Vth distributions experimentally obtained for memory cells belonging to a memory sector cycled after programming and after retention at 150°C. It is immediately observed that the above described phenomenon of "natural" charge release (indicated with the English word "detrapping") strongly depends on the temperature, since this facilitates the emission of the electric charges or carriers of the traps increasing the thermal energy, but it also depends on the electric field since this alters the form of the trap potential barrier also allowing the passage of the carriers assisted by the so called tunnel effect.

It is thus comprised how the "detrapping" phenomenon is dangerous mainly at high temperatures and is particularly sensitive on logic levels placed at thresholds corresponding to high electric fields in retention. This "detrapping" phenomenon is thus particularly critical for the multilevel devices, which can have a wider reading threshold window with respect to the one-level or single bit devices and which also have very fine threshold margins between the different logic levels stored therein.

It is well known that the release times of the electric charges accumulated in the tunnel oxide layer 6 can be very long (even years) at environment temperatures, while they are definitely reduced at higher temperatures.

Flash memory devices currently on sale have retention specifications for a time equal to 10 years and operative temperatures up to 85-125°C.

For a reliable operation of a memory device during its whole operative life it is thus necessary to suitably design it and in particular to reserve, in the threshold window, a suitable margin for ensuring the correct reading of the different logic levels also in the presence of possible shifts of the threshold voltage of the memory cells comprised therein.

However, the resulting widening of the threshold window has the effect of worsening other reliability aspects of the memory device, linked to the general enhancement of the electric fields associated to the device itself.

FR-A-2809858 discloses a method according to the preamble of claim 1. More specifically, a method of programming and erasing a flash memory module is disclosed, wherein a plurality of flash memory cells are arrayed in a substrate, each memory cell having a source, a drain, a floating gate, and a control gate, which are separated from one another on the substrate, an insulating layer formed on the substrate between the source and drain, and also separating the source/drain and control gate, and a floating gate. A detrapping process with appropriate bias conditions is applied either after an erase step for erasing data written to the flash memory cell or after a write step for writing predetermined data, in order to remove electrons trapped in the insulating layer excluding the floating gate. During the detrapping process, electrons trapped in a region excluding a floating gate are removed, thereby suppressing degradation caused by repeated write/erase operations.

The technical problem underlying the present invention is that of improving such a method for programming/erasing a non volatile memory device as to eliminate the degradation of the threshold value of the memory cells comprised therein during the programming/erasing steps as well as the effects of trapping and releasing of electric charge inside the cells themselves, without limiting neither the speed of these programming/erasing steps nor the reliability of the device in general, so as to overcome the limits and the drawbacks still affecting the methods for programming/erasing non volatile memory devices realised according to the prior art.

### Summary of the Invention

According to an aspect, the present invention provides a method of programming and erasing a non volatile memory cell, according to the subject-matter of independent claim 1. Further aspects of the invention are set forth in the dependent claims, the following description and the drawings.

The characteristics and the advantages of the programming/erasing method according to the invention will be apparent from the following description of an embodiment thereof given by way of indicative and non limiting example with reference to the annexed drawings.

### Brief description of the drawings

In these drawings:
Figures 1A and 1B schematically show a floating gate non volatile memory cell realised according to the prior art;
Figures 2A and 2B show the trend of characteristic parameters of the cell of Figures 1A and 1B;
Figures 3A and 3B schematically show the trend of a threshold value of non volatile memory cells, in particular belonging to a same memory sector, during a programming step and an erasing step, respectively, realised according to the method of the present invention;
Figures 4A and 4B show the mean variation of a threshold voltage of memory cells programmed/erased according to the method of the present invention;
Figures 5A and 5B schematically show the trend of a threshold value of single-level non volatile memory cells, in particular belonging to a same memory sector, during a programming step and an erasing step, respectively, realised according to the method of the present invention;
Figures 6A and 6B schematically show the trend of a threshold value of two-level non volatile memory cells, in particular belonging to a same memory sector, during a programming step and an erasing step, respectively, realised according to the method of the present invention; and
Figure 7 shows experimental results of the method according to the invention applied to a memory device of the Flash type.

### Detailed description of embodiments

Advantageously according to the invention, a method is proposed for programming/erasing a memory device comprising at least one electric stress step suitable for applying, to the memory cells, an electric field able to remove at least a part of the electric charges trapped in the respective tunnel oxide layers. The method is used for devices with memory cells of the floating gate type, described in relation with the prior art and shown in Figures 1A and 1B.

It is to be noted that the electric stress step essentially comprises the application, to one or more terminals of at least one memory cell 1, of potentials able to produce an electric field on a corresponding active oxide layer. The words "active oxide layer" indicate the cell layer crossed by a writing current and being trapping seat of an amount Q of charge, in particular the tunnel oxide layer 6 as previously described. In substance, the electric stress step thus comprises a biasing step of at least one terminal of the memory cell 1 for generating a desired electric field in the active oxide layer.

It is to be noted that, advantageously according to the invention, the electric field generated by the electric stress step in the active oxide layer must be enough to cause the release of at least a part of the amount Q of charge trapped in the active oxide layer, as indicated in particular in Figure 1B.

In particular, to be efficient in releasing such part of amount 9 of trapped charge, the resulting electric field is fixed so as to be high enough as to defeat the forces linking the charges 9 to the corresponding traps. Moreover, advantageously according to the invention, this resulting electric field is fixed so as not to be so high as to generate a current which would cross the active oxide layer, in a way similar to the writing current of the memory cell 1. In this way, the resulting electric field does not cause a generation of new traps, with the consequent creation of an amount of charge even greater with respect to the release of the part of amount 9 of trapped charge, as it occurs exactly during the writing operations.

To determine such a value for this resulting electric field as to meet the above indicated conditions and as to determine a condition of sole charge release from the already existing traps, the programming/ erasing method according to the invention advantageously comprises a step of testing a memory device which must be subjected to the programming/erasing operations.

In particular, this test step comprises an experimental verify step of a group of memory cells, in particular a memory sector, under different stress conditions, corresponding to different values of the potentials applied to their terminals, subjected to a predetermined number of repeated writing operations, in turn comprising, in a known way, cyclings of programming/erasing operations to determine the desired electric field value to be applied during the electric stress step.

The experimental verify step comprises the following steps:
- at the end of each one of the cyclings of programming/erasing operations, a test writing step during which all the memory cells of the group are written at a same threshold value Vt;
- a retention test step accelerated by temperature, by means of which a measurement is carried out of a threshold variation of the group of cells occurred during a predetermined period when the memory device is left at a constant temperature value without carrying out further writing operations.

In particular, the test step provides a reading of the group of cells prior to and after the application of an electric stress.

In this way, the experimental verify step allows to obtain the best conditions of the potentials applied to the terminals of the cells for a correct electric stress step, as those for which the threshold variation measured in the test step is at its minimum value.

Advantageously according to the invention, the experimental verify step also comprises a step of identifying a maximum value of the electric field applicable in the electric stress step, i.e. a maximum value of the potentials applicable to the terminals of the memory cell by the electric stress step to avoid a current generation similar to the writing current.

In particular, the identification step comprises the following steps:
- application of a stress electric field on a non cycled cell for different values of this stress electric field;
- measurement of a variation of the cell threshold occurred between prior to and after the application of this stress electric field;
- identification of a maximum value of this stress electric field corresponding to a significant variation of the cell threshold, in particular corresponding to a threshold variation of the cell when a writing operation is carried out with a non negligible writing current.

Possibly, the identification step provides a repetition in sequence of the application of the stress electric field.

It is to be noted that the identification step of the highest value of the electric field applicable in the electric stress step allows to identify the electric field value which produces a current similar to a non negligible writing current, i.e. the critical condition wherein the application of the stress electric field could give a neat balance of trap generation and thus of charge entrapped in the active oxide layer.

This applied electric field is preferably comprised between 2MV/cm and 10MV/cm.

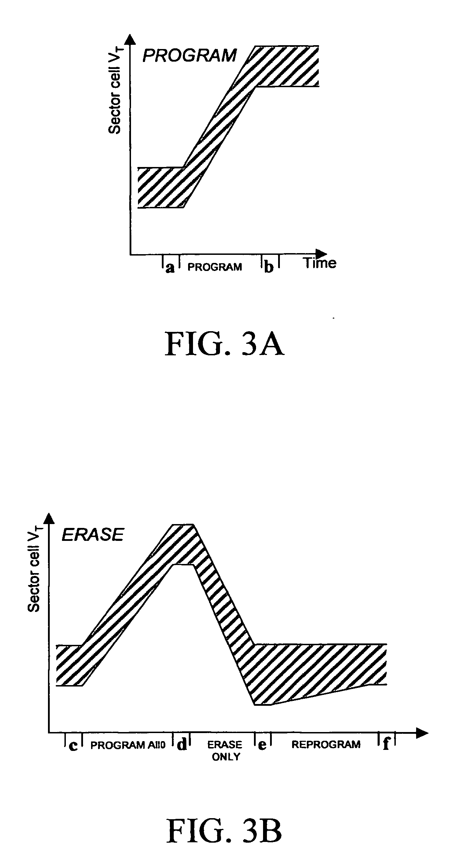

Advantageously according to the invention, the electric stress step is inserted in a programming/erasing method of the known type, in correspondence with writing operations of the memory cells of the device subjected to the programming/erasing operations, as schematically shown in Figures 3A and 3B for a programming and erasing operation, respectively, in the positions indicated with (a)-(f).

In particular, the electric stress step is inserted prior to and after the application of a programming pulse, indicated with program, i.e. in the positions (a) and (b) of Figure 3A for a programming operation and in the positions (c) and (d) of Figure 3B for an erasing operation. Moreover, this electric stress step is inserted prior to and after the application of a reprogramming pulse, indicated with reprogram, i.e. in the positions (e) and (f) of Figure 3B for an erasing operation.

In general, the programming/ erasing method according to the invention comprises an electric stress step:
- during a programming operation:
   i. at the beginning of this operation (point a) and/or
   ii. at the end of the same (point b);
- during an erasing operation:
   i. at the beginning of this operation (point c)
   ii. after an initial programming step (point d)
   iii. after the real erasing step (point e)
   iv. after the reprogramming step (point f)

The electric stress step causes, in this way, at each writing cycle of the memory cells, a release of a part of the charge trapped in the active oxide layer 6, this charge entrapment being caused by the writing cycle itself and/or by preceding writing cycles.

In this way, the method according to the invention allows to limit the charge accumulation in this active oxide layer and to reduce all the possible effects, comprised the charge release when a cell is in retention.

In a preferred embodiment of the method according to the invention, for using an application time of this electric stress step as long as possible (in the order of ms), the electric stress step is inserted during the erasing step.

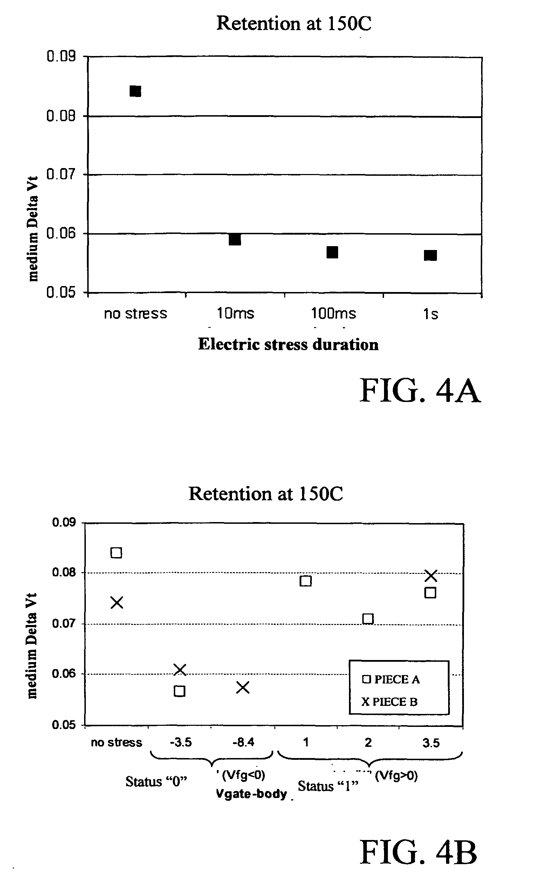

In particular, in the case of a memory device of the Flash NOR type, the electric stress step is inserted during the sector erasing step, whose duration is already of some hundreds of ms and thus is not prolonged a lot in percentage, as schematically shown in Figure 4A.

It is to be noted that, in this case, the execution of the electric stress step in correspondence with the positions from (c) to (e) indicated in Figure 3B for the erasing step, in parallel on all the cells of a sector in the case of a memory device of the Flash NOR type, is not dangerous for the disturbance of the logic data already written in these cells, since during the erasing step all and only the cells of the sector are re-written at the logic value "1" in a definitive way only in the point indicated with (f) in Figure 3B.

Moreover, in a preferred embodiment of the method according to the invention, the electric stress step is realised in parallel on all the cells, by means of application of a same stress potential to a given electrode of the cells, identical for all the cells of the sector.

It is also possible to realise the electric stress step in a sequential way, by applying a given stress potential in a sequential way on groups of different cells each time, for example by scanning the rows or the columns. In this case, however, an increase of the total time of the writing operation occurs.

In any case, it is possible to insert this electric stress step during the programming step, for example of one or more words, limiting the duration thereof, to remain within the normal times of execution of this programming step equal to some tens of µs.

In this case, it is to be taken into account that the application of the stress potential during a programming operation of one or more words could imply a disturbance on the data stored in the cells which are not involved in the writing operation interested in the electric stress step, also when this electric stress step was realised in a selective way on the sole cells interested in the writing operation.

It is however to be reminded that the method according to the invention is generally applicable to memory devices of the Flash NOR or NAND type, but also to memories with nano-crystals, with discrete traps and with nitride, e.g. NROM.

In general, the choice of the moment when the electric stress step is to be carried out depends on considerations regarding the control circuitry of the memory device considered, in combination with the choice of the most efficient electric potentials for the charge release from the traps.

It has been experimentally observed that an electric stress step with application of a stress potential for the Control Gate terminals being lower than the stress potentials of the body, source and drain terminals, maintained almost equi-potential, is efficient for a neat charge release from the traps.

It occurs that this release is weakly dependant on the electric field for voltage values between Control Gate and body terminals comprised between -3.5V and -8.4V provided on a cell in the programmed state, as shown in Figure 4B.

Therefore, in a preferred embodiment of the method according to the invention, it follows that the electric stress step is realised just prior to the erasing step, i.e. in the position (d) of Figure 3B. In fact, in this position, the pulses applied to the electrodes of the cell have similar duration and potentials with the same sign, but different width, thus facilitating the circuit implementation of the method.

In particular, it is possible to apply a stress potential to the void body terminal and to the negative Control Gate terminal, but also a different distribution of the voltage between the two electrodes allows to obtain the desired charge release.

Advantageously, the electric stress step according to the invention comprises the application of a potential, i.e. the biasing, of the electrode of
- gate
- substrate or body
- source
- drain
these potentials being both positive and negative and this biasing involving more than one electrode simultaneously.

Advantageously according to the invention, the electric stress step comprises the application of stress potentials by means of one or more pulses, rectangular or of other form (for example ramp-like), according to the circuit implementation convenience of the same.

It is to be remarked that the considerations made for the explanatory case of a memory device of the Flash NOR type are applicable in general.

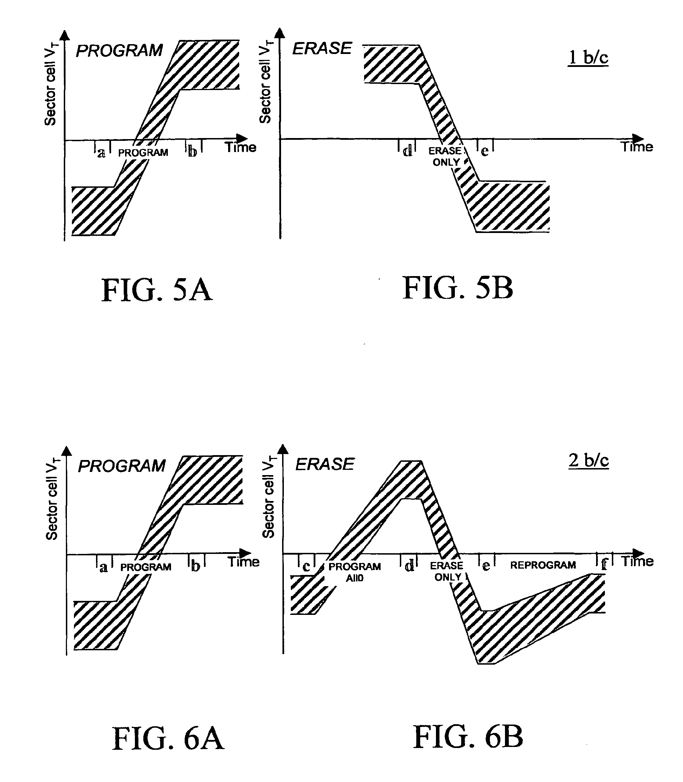

For example, in the case of a memory device of the Flash NAND type, it is however possible to insert the electric stress step according to the invention in any point of a programming/erasing method of the known type, as schematically shown in Figures 5A-5B and 6A-6B for the case of two-level (1 bit per cell) and multilevel (two bits per cell) devices, respectively.

Also in this case, since the duration of a programming operation can be of a few hundreds of µs for devices with 1 bit per cell up to almost 1ms for devices with 2 bits per cell, it is possible to insert the electric stress step according to the invention in such a programming operation with duration in the order of the ten of µs, in particular in the points indicated with (a) and/or (b) in Figures 5A and 6A, preferring point (a) since in correspondence with this point the logic datum stored in the cells interested in the electric stress step has not been described yet. Also in this case a disturbance on other cells different from those interested in the writing operation is inevitable.

Similarly, the insertion of the electric stress step during an erasing operation has the advantage of applying longer pulses, the duration of this operation being equal to a few ms. In particular, by inserting the electric stress step in the points indicated with (c), (d) and (e) the advantage is obtained of avoiding the generation of disturbances on a logic datum stored in the cells interested in the stress step, these having to be written in a definitive way only at point (f).

It is to be remarked that the electric stress step is inserted in a normal method for programming/erasing a memory device, of the type already used in the sector and it is possible to implement it by using the normal control circuitry these devices are provided with.

In particular, in the case shown of a memory device of the Flash NAND type, the control circuitry is normally realised for managing only positive voltages. It is however possible to apply stress potentials similar to those previously indicated for the devices of the Flash NOR type, i.e. with a negative voltage value between Control Gate and body terminals in the order of some Volt, by simply maintaining the potential of the Control Gate terminal to ground and enhancing the potential of the body terminal to a desired positive value.

Moreover, according to the needs of simplification of the control circuitry, also different distributions of the potentials onto the electrodes are possible for generating a same voltage or form of the pulses different from a simple rectangular pulse, as for example a ramp pulse or a sequence of more pulses can be contemplated.

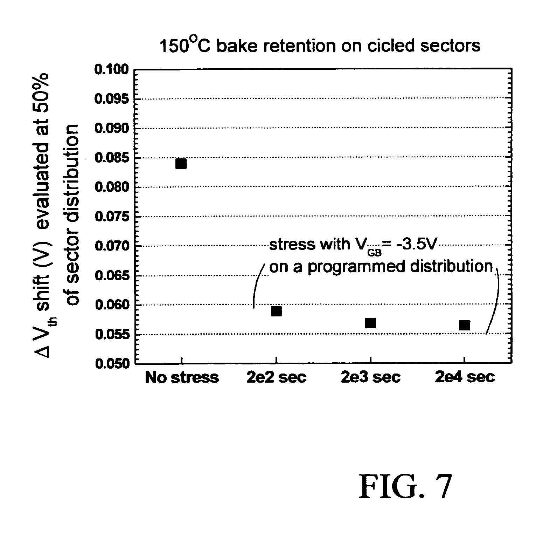

From experimental tests carried out by the Applicant itself, the beneficial effect has been observed of an electric stress step with voltage applied between body and gate on cycled sectors, with verification that the charge released during the retention test at 150°C after cycling of 20k cycles is remarkably reduced for a sector whereon the electric stress step according to the invention has been applied, with respect to a sector without applied stresses, as schematically shown in Figure 7.

In particular, a 50% threshold shift of the sector cells has been measured for a sector non subjected to the electric stress step and for other sectors subjected to the electric stress step according to the invention with increasing times. This threshold shift is in fact due to the charge released by the traps and is proportional, with identical electric field conditions, times and temperatures, to the trapped charge itself.

It has thus been verified how it is possible to use electric stress steps of short duration, however efficient for the charge release, and which do not excessively prolong the writing time of the data in the memory device, this being a parameter to be maintained as low as possible.

In conclusion, the programming/erasing method according to the invention allows to reduce the effects of threshold variation of the memory cells interested in the programming/erasing steps during the retention steps of the same, to moderate the increase in the programming/erasing times of the memory device comprising these cells, and, simultaneously, to avoid other reliability problems due to the accumulation of charge trapped in the tunnel oxide layers of the cells.

## Claims

1. A method comprising:
applying an electric field to remove electric charge trapped in an oxide layer associated with a floating gate of at least one memory cell of a non-volatile memory device,
**characterised by**:
testing said memory device including cycling programming and erasing operations to determine said electric field to be applied to remove said electric charge from said oxide layer.

2. The method according to claim 1, wherein said electric field application step comprises an application of an electric field potential to at least one terminal of said memory cell.

3. The method according to claim 1, wherein said electric field application step provides said electric field with a value sufficient to defeat forces linking charges to respective traps in said oxide layer.

4. The method according to claim 3, wherein said electric field application step provides said electric field with a lower value than an electric field value suitable for generating a current in said oxide layer.

5. The method according to claim 1, further comprising a verification step of a group of memory cells for different values of electric field potentials applied thereto, and comprising:
- at the end of each one of the programming/erasing cycles, a test writing step during which said memory cells of said group are written at a same threshold value;
- a retention test step accelerated by temperature, via which a measurement is carried out of a threshold variation of said group of memory cells occurring during a period when said memory device is left at a temperature constant value without carrying out further writing operations.

6. The method according to claim 5, further comprising reading of said group of cells prior to and after the application of said electric field to said oxide layer.

7. The method according to claim 5, wherein said verification step establishes optimal electric field conditions in correspondence with said threshold variation measured in the testing at a minimum value.

8. The method according to claim 5, wherein said verification step further comprises an identification step to identify a maximum value of said electric field based on an absence of a current in said oxide layer.

9. The method according to claim 8, further comprising the following steps:
- application of said electric field to a non-cycled cell for different electric field values;
- measurement of a threshold variation of said cell occurred between prior to and after said application of said electric field; and
- identification of a maximum value of said electric field based upon a significant variation of said measured threshold.

10. The method according to claim 9, wherein said identification step further comprises a repeating of said application of said electric field.

11. The method according to any of the preceding claims, wherein said electric field application step is inserted in correspondence with a writing operation of said cells of said memory device.

12. The method according to claim 11, wherein said electric field application step is performed prior to a programming operation.

13. The method according to claim 11, wherein said electric field application step is performed after a programming operation.

14. The method according to claim 11, wherein said electric field application step is performed prior to an erasing operation.

15. The method according to claim 11, wherein said electric field application step is performed after an initial programming step of an erasing operation.

16. The method according to claim 11, wherein said electric field application step is performed after a real erasing step of an erasing operation.

17. The method according to claim 11, wherein said electric field application step is performed after a reprogramming step of an erasing operation.

18. The method according to claim 11, wherein said electric field application step comprises an application of said electric field for a duration corresponding to a duration of said writing operation.

19. The method according to claim 11, wherein said electric field application step comprises an application of said electric field in parallel on a plurality of said memory device.

20. The method according to claim 11, wherein said electric field application step comprises an application of said electric field sequentially on groups of different cells of said memory device.

21. The method according to claim 2, wherein said application of said electric field potential to at least one terminal of said memory cell comprises a biasing step of at least one electrode of said memory cell between a control gate, substrate or body, source and drain electrode.

22. The method according to claim 21, wherein said application of said electric field potential includes positive and negative potentials.

23. The method according to claim 21, wherein said application of said electric field potential includes applying the electric field potential to more than one electrode of said memory cell simultaneously.

24. The method according to claim 21, wherein said application of said electric field potential comprises applying the electric field potential to a control gate terminal lower than a stress potential of body, source and drain terminals, maintained substantially on the same potential.

25. The method according to claim 2, wherein said electric field application step comprises applying the electric field potential via one or more rectangular pulses.

26. The method according to claim 2, wherein said electric field application step comprises applying the electric field potential via one or more ramp pulses.

27. The method according to any of the preceding claims, wherein said electric field application step is performed on a group of memory cells.

28. The method according to claim 27, wherein said group of memory cells corresponds to a sector of said device.

## Patentansprüche

1. Verfahren, umfassend:
Anlegen eines elektrischen Feldes, um eine elektrische Ladung zu entfernen, die in einer Oxidschicht gefangen ist, die einem Floating-Gate von wenigstens einer Speicherzelle einer nicht flüchtigen Speichervorrichtung zugeordnet ist,
**gekennzeichnet durch**:
Testen der Speichervorrichtung einschließlich periodischen Durchlaufens von Programmier- und Löschoperationen, um das elektrische Feld zu bestimmen, das angelegt werden muss, um die elektrische Ladung von der Oxidschicht zu entfernen.

2. Verfahren nach Anspruch 1, bei welchem das Anlegen des elektrischen Feldes ein Anlegen eines elektrischen Feldpotentials an wenigstens einen Anschluss der Speicherzelle umfasst.

3. Verfahren nach Anspruch 1, bei welchem das Anlegen des elektrischen Feldes das elektrische Feld mit einem Wert bereitstellt, der ausreicht, um Kräfte zu überwinden, die Ladungen an entsprechende Haftstellen in der Oxidschicht binden.

4. Verfahren nach Anspruch 3, bei welchem das Anlegen des elektrischen Feldes das elektrische Feld mit einem niedrigeren Wert bereitstellt als ein elektrischer Feldwert, der geeignet ist, einen Strom in der Oxidschicht zu erzeugen.

5. Verfahren nach Anspruch 1, des weiteren eine Bestätigung einer Gruppe von Speicherzellen für unterschiedliche Werte von elektrischen Feldpotentialen umfassend, die daran angelegt sind, und umfassend:
- am Ende jeden Programmier-/Löschdurchlaufs ein Testschreiben, während dem die Speicherzellen der Gruppe mit dem gleichen Schwellwert beschrieben werden;
- einen Speicherungstest, der durch Temperatur beschleunigt wird, durch welchen eine Messung von Schwellwertvariationen der Gruppe von Speicherzellen durchgeführt wird, die stationär während einer Zeitspanne stattfindet, wenn die Speichervorrichtung bei einem konstanten Temperaturwert belassen wird, ohne dass weitere Schreiboperationen durchgeführt werden.

6. Verfahren nach Anspruch 5, des weiteren Lesen der Gruppe von Zellen umfassend, bevor und nachdem das elektrische Feld an die Oxidschicht angelegt wird.

7. Verfahren nach Anspruch 5, bei welchem die Bestätigung optimale elektrische Feldbedingungen ermittelt, entsprechend der Schwellwertvariation, die beim Testen bei einem Minimalwert gemessen wurde.

8. Verfahren nach Anspruch 5, bei welchem die Bestätigung des weiteren eine Identifizierung umfasst, um einen Maximalwert des elektrischen Feldes basierend auf einer Abwesenheit eines Stroms in der Oxidschicht zu bestimmen.

9. Verfahren nach Anspruch 8, des weiteren die folgenden Schritte umfassend:
- Anlegen des elektrischen Feldes an eine nicht zyklisch durchlaufene Zelle für verschiedene elektrische Feldwerte;
- Messen einer Schwellwertveränderung der Zelle, die zwischen vor und nach dem Anlegen des elektrischen Feldes stattgefunden hat; und
- Identifizieren eines Maximalwerts des elektrischen Feldes, basierend auf einer signifikanten Veränderung des gemessenen Schwellwerts.

10. Verfahren nach Anspruch 9, bei welchem das Identifizieren des weiteren ein Wiederholen des Anlegens des elektrischen Feldes umfasst.

11. Verfahren nach einem der vorstehenden Ansprüche, bei welchem das Anlegen des elektrischen Feldes entsprechend einer Schreiboperation der Zelle der Speichervorrichtung eingefügt wird.

12. Verfahren nach Anspruch 11, bei welchem das Anlegen des elektrischen Feldes vor einer Programmieroperation durchgeführt wird.

13. Verfahren nach Anspruch 11, bei welchem das Anlegen des elektrischen Feldes nach einer Programmieroperation durchgeführt wird.

14. Verfahren nach Anspruch 11, bei welchem das Anlegen des elektrischen Feldes vor einer Löschoperation durchgeführt wird.

15. Verfahren nach Anspruch 11, bei welchem das Anlegen des elektrischen Feldes nach einer anfänglichen Programmierung einer Löschoperation durchgeführt wird.

16. Verfahren nach Anspruch 11, bei welchem das Anlegen des elektrischen Feldes nach einem echten Löschen einer Löschoperation durchgeführt wird.

17. Verfahren nach Anspruch 11, bei welchem das Anlegen des elektrischen Feldes nach einem Neuprogrammieren einer Löschoperation durchgeführt wird.

18. Verfahren nach Anspruch 11, bei welchem das Anlegen des elektrischen Feldes ein Anlegen des elektrischen Feldes für eine Dauer umfasst, die einer Dauer der Schreiboperation entspricht.

19. Verfahren nach Anspruch 11, bei welchem das Anlegen des elektrischen Feldes ein Anlegen des elektrischen Feldes parallel auf mehreren Speichervorrichtungen umfasst.

20. Verfahren nach Anspruch 11, bei welchem das Anlegen des elektrischen Feldes ein Anlegen des elektrischen Feldes nacheinander an Gruppen von verschiedenen Zellen der Speichervorrichtung umfasst.

21. Verfahren nach Anspruch 2, bei welchem das Anlegen des elektrischen Feldpotentials an wenigstens einem Anschluss der Speicherzelle ein Vorspannen von wenigstens einer Elektrode der Speicherzelle zwischen einer Steuergate-, Substrat oder Körper, Source- und Drain-Elektrode umfasst.

22. Verfahren nach Anspruch 21, bei welchem das Anlegen des elektrischen Feldpotentials positive und negative Potentiale umfasst.

23. Verfahren nach Anspruch 21, bei welchem das Anlegen des elektrischen Feldpotentials Anlegen des elektrischen Feldpotentials an mehr als eine Elektrode der Speicherzelle gleichzeitig umfasst.

24. Verfahren nach Anspruch 21, bei welchem das Anlegen des elektrischen Feldpotentials Anlegen des elektrischen Feldpotentials an einen Steuergateanschluss umfasst, das niedriger ist als ein Belastungspotential von Körper-, Source- und Drain-Anschlüssen, die im Wesentlichen auf dem gleichen Potential gehalten werden.

25. Verfahren nach Anspruch 2, bei welchem das Anlegen des elektrischen Feldes Anlegen des elektrischen Feldpotentials durch einen oder mehrere Rechteckimpulse umfasst.

26. Verfahren nach Anspruch 2, bei welchem das Anlegen des elektrischen Feldes Anlegen des elektrischen Feldpotentials durch einen oder mehrere Rampenimpulse umfasst.

27. Verfahren nach einem der vorstehenden Ansprüche, bei welchem das Anlegen des elektrischen Feldes an einer Gruppe von Speicherzellen durchgeführt wird.

28. Verfahren nach Anspruch 27, bei welchem die Gruppe von Speicherzellen einem Sektor der Vorrichtung entspricht.

## Revendications

1. Procédé consistant à :
appliquer un champ électrique pour retirer une charge électrique piégée dans une couche d'oxyde associée à une grille flottante d'au moins une cellule de mémoire d'un dispositif de mémoire non volatile,
**caractérisé en ce que** :
le test dudit dispositif de mémoire comprend des opérations de programmation et d'effacement de cycles pour déterminer ledit champ électrique à appliquer pour retirer ladite charge électrique de ladite couche d'oxyde.

2. Procédé selon la revendication 1, dans lequel ladite étape d'application de champ électrique comprend une application d'un potentiel de champ électrique à au moins une borne de ladite cellule de mémoire.

3. Procédé selon la revendication 1, dans lequel ladite étape d'application de champ électrique applique ledit champ électrique avec une valeur suffisante pour annuler les forces liant les charges aux pièges respectifs dans ladite couche d'oxyde.

4. Procédé selon la revendication 3, dans lequel ladite étape d'application de champ électrique applique ledit champ électrique avec une valeur inférieure à une valeur de champ électrique appropriée pour générer un courant dans ladite couche d'oxyde.

5. Procédé selon la revendication 1, comprenant en outre une étape de vérification d'un groupe de cellules de mémoire pour différentes valeurs de potentiels de champ électrique appliquées à celles-ci, et comprenant :
- à la fin de chacun des cycles de programmation/effacement, une étape d'écriture de test pendant laquelle lesdites cellules de mémoire dudit groupe sont écrites à une même valeur de seuil ;
- une étape de test de maintien accélérée par la température, par laquelle une mesure est effectuée d'une variation de seuil dudit groupe de cellules de mémoire apparaissant pendant une période lorsque ledit dispositif de mémoire est laissé à une valeur de température constante sans exécuter d'autres opérations d'écriture.

6. Procédé selon la revendication 5, comprenant en outre la lecture dudit groupe de cellules avant et après l'application dudit champ électrique à ladite couche d'oxyde.

7. Procédé selon la revendication 5, dans lequel ladite étape de vérification établit des conditions de champ électrique optimales en correspondance avec ladite variation de seuil mesurée lors du test à une valeur minimum.

8. Procédé selon la revendication 5, dans lequel ladite étape de vérification comprend en outre une étape d'identification pour identifier une valeur maximum dudit champ électrique sur la base d'une absence d'un courant dans ladite couche d'oxyde.

9. Procédé selon la revendication 8, comprenant en outre les étapes suivantes consistant à :
- appliquer ledit champ électrique à une cellule non cyclée pour différentes valeurs de champ électrique ;
- mesurer une variation de seuil de ladite cellule apparue entre avant et après ladite application dudit champ électrique ; et
- identifier une valeur maximum dudit champ électrique sur la base d'une variation significative dudit seuil mesuré.

10. Procédé selon la revendication 9, dans lequel ladite étape d'identification comprend en outre une répétition de ladite application dudit champ électrique.

11. Procédé selon l'une quelconque des revendications précédentes, dans lequel ladite étape d'application de champ électrique est insérée en correspondance avec une opération d'écriture desdites cellules dudit dispositif de mémoire.

12. Procédé selon la revendication 11, dans lequel ladite étape d'application de champ électrique est effectuée avant une opération de programmation.

13. Procédé selon la revendication 11, dans lequel ladite étape d'application de champ électrique est effectuée après une opération de programmation.

14. Procédé selon la revendication 11, dans lequel ladite étape d'application de champ électrique est effectuée avant une opération d'effacement.

15. Procédé selon la revendication 11, dans lequel ladite étape d'application de champ électrique est effectuée après une étape de programmation initiale d'une opération d'effacement.

16. Procédé selon la revendication 11, dans lequel ladite étape d'application de champ électrique est effectuée après une étape d'effacement réel d'une opération d'effacement.

17. Procédé selon la revendication 11, dans lequel ladite étape d'application de champ électrique est effectuée après une étape de reprogrammation d'une opération d'effacement.

18. Procédé selon la revendication 11, dans lequel ladite étape d'application de champ électrique comprend une application dudit champ électrique pendant une durée correspondant à une durée de ladite opération d'écriture.

19. Procédé selon la revendication 11, dans lequel ladite étape d'application de champ électrique comprend une application dudit champ électrique en parallèle à une pluralité desdits dispositifs de mémoire.

20. Procédé selon la revendication 11, dans lequel ladite étape d'application de champ électrique comprend une application dudit champ électrique séquentiellement à des groupes de différentes cellules dudit dispositif de mémoire.

21. Procédé selon la revendication 2, dans lequel ladite application dudit potentiel de champ électrique à au moins une borne de ladite cellule de mémoire comprend une étape de polarisation d'au moins une électrode de ladite cellule de mémoire parmi une électrode de grille de commande, de substrat ou de corps, de source et de drain.

22. Procédé selon la revendication 21, dans lequel ladite application dudit potentiel de champ électrique comprend des potentiels positifs et négatifs.

23. Procédé selon la revendication 21, dans lequel ladite application dudit potentiel de champ électrique comprend l'application du potentiel de champ électrique à plusieurs électrodes de ladite cellule de mémoire simultanément.

24. Procédé selon la revendication 21, dans lequel ladite application dudit potentiel de champ électrique comprend l'application du potentiel de champ électrique à une borne de grille de commande inférieur à un potentiel de contrainte des bornes de corps, de source et de drain, maintenues sensiblement au même potentiel.

25. Procédé selon la revendication 2, dans lequel ladite étape d'application de champ électrique comprend l'application du potentiel de champ électrique par l'intermédiaire d'une ou de plusieurs impulsions rectangulaires.

26. Procédé selon la revendication 2, dans lequel ladite étape d'application de champ électrique comprend l'application du potentiel de champ électrique par l'intermédiaire d'une ou de plusieurs impulsions de rampe.

27. Procédé selon l'une quelconque des revendications précédentes, dans lequel ladite étape d'application de champ électrique est appliquée à un groupe de cellules de mémoire.

28. Procédé selon la revendication 27, dans lequel ledit groupe de cellules de mémoire correspond à un secteur dudit dispositif.
